# EUROPEAN PATENT APPLICATION

(11) **EP 4 742 863 A1**
(43) Date of publication of application: **13.05.2026**
(21) Application number: 24848253.1
(22) Date of filing: 30.07.2024
(51) Int. Cl.: H10F 77/70, H10F 77/20, H10F 77/14, H10F 10/166, H10F 30/295, H10F 71/10

(54) **HETEROJUNCTION SOLAR CELL AND PREPARATION METHOD THEREFOR**

(30) Priority: 02.08.2023 CN 202310970322
(71) Applicant: Trina Solar Co., Ltd, Changzhou, Jiangsu 213031 (CN); Trina Solar (Changzhou) Science & Technology Co., Ltd, Changzhou Jiangsu 213031 (CN)
(72) Inventor: GAO, Jifan, Changzhou, Jiangsu 213031 (CN); MENG, Zibo, Changzhou, Jiangsu 213031 (CN); BAI, Yanhui, Changzhou, Jiangsu 213031 (CN); LI, Hongwei, Changzhou, Jiangsu 213031 (CN); HUO, Tingting, Changzhou, Jiangsu 213031 (CN); HOU, Chengli, Changzhou, Jiangsu 213031 (CN); YANG, Guangtao, Changzhou, Jiangsu 213031 (CN); CHEN, Daming, Changzhou, Jiangsu 213031 (CN)
(74) Representative: Meissner Bolte Partnerschaft mbB
(86) International application number: PCT/CN2024/108364
(87) International publication number: WO 2025/026298

(57) **Abstract**

Embodiments of the present disclosure provide a heterojunction solar cell and a preparation method therefor. The heterojunction solar cell comprises: a silicon substrate, wherein at least one of the front and back surfaces of the silicon substrate is a textured surface of a pyramid structure; silicon-based thin films provided on the front and back surfaces of the silicon substrate, wherein each silicon-based thin film comprises an intrinsic layer and a doped layer provided on the side of the intrinsic layer facing away from the silicon substrate, the doping types of the doped layers provided on the front and back surfaces of the silicon substrate are opposite, and the thickness of the silicon-based thin film covering the pyramid structure decreases as the silicon-based thin film covering the pyramid structure gets closer the silicon substrate; and a transparent conductive layer and grid electrodes provided on the side of each silicon-based thin film facing away from the silicon substrate. The apex of the pyramid structure is a stress concentration point, and the stress gradually decreases in a downward direction. In the coating process of the transparent conductive layer, because the silicon-based thin film at the apex is thick, the transparent conductive material in an apex area can be prevented from being bombarded into an interface of the silicon substrate, thereby preventing interface recombination and improving the efficiency of heterojunction solar cells.

## Description

### Cross-reference to related applications

The present disclosure claims the priority to Chinese Patent Application No. 202310970322.8, filed on August 02, 2023, and entitled "Heterojunction Solar Cell and Preparation Method therefor", the entire contents of which are incorporated herein by reference.

### Technical field

The present disclosure relates to the field of solar cell technologies, and in particular, to a heterojunction solar cell and a preparation method therefor.

### Background

Heterojunction with Intrinsic Thin layer (HJT) solar cells are receiving increasing attention in the industry. The heterojunction cell structure typically takes a silicon substrate as the center, and an intrinsic amorphous silicon thin film is deposited between the doped amorphous silicon on both sides of the silicon substrate and the silicon substrate. After adopting this process measure, the performance of the PN junction is improved, thereby increasing the conversion efficiency of the heterojunction solar cell.

How to improve the cell efficiency of heterojunction solar cells is a topic considered by the industry.

### Summary of the invention

In view of the disadvantages of the related art described above, the present disclosure aims to provide a heterojunction solar cell and a preparation method therefor, so as to solve the technical problem of low efficiency of heterojunction solar cells in the related art.

A first aspect of the present disclosure provides a heterojunction solar cell, comprising:
a silicon substrate comprising a front side and a back side, wherein at least one of the front surface and the back surface is provided as a textured surface having a pyramid structure;
a silicon-based thin film disposed on the front surface and the back surface of the silicon substrate, the silicon-based thin film comprising an intrinsic layer and a doped layer disposed on a side of the intrinsic layer away from the silicon substrate; wherein a doping type of the doped layer on the front surface is opposite to a doping type of the doped layer on the back surface, and a thickness of the silicon-based thin film covering the pyramid structure decreases closer to the silicon substrate; and
a transparent conductive layer and grid electrodes disposed on a side of each silicon-based thin film away from the silicon substrate.

In some embodiments, the intrinsic layer is a double-layer structure,
the intrinsic layer comprises: an intrinsic hydrogenated amorphous silicon oxide layer and an intrinsic hydrogenated nanocrystalline silicon layer; and
the intrinsic hydrogenated amorphous silicon oxide layer is closer to the silicon substrate than the intrinsic hydrogenated nanocrystalline silicon layer.

In some embodiments, a thickness of the intrinsic hydrogenated amorphous silicon oxide layer is 4-8 nm.

In some embodiments, a thickness of the intrinsic hydrogenated nanocrystalline silicon layer is 5-10 nm.

In some embodiments, the doped layer is a doped microcrystalline silicon oxycarbide layer.

In some embodiments, the doped microcrystalline silicon oxycarbide layer located on the front surface of the silicon substrate has N-type dopant, an activation concentration of N-type dopant is not less than 1E+17/cm³; and the doped microcrystalline silicon oxycarbide layer located on the back surface of the silicon substrate has P-type dopant, an activation concentration of P-type dopant is not less than 1E+16/cm³.

In some embodiments, a doping concentration of the doped layer increases in a direction from the silicon substrate toward the grid electrodes.

In some embodiments, the doped layer disposed on the front surface of the silicon substrate has N-type dopant,
the doped layer disposed on the back surface of the silicon substrate has P-type dopant; and
a grid density of the grid electrodes located on the front surface of the silicon substrate is greater than a grid density of the grid electrodes located on the back surface of the silicon substrate.

In some embodiments, the heterojunction solar cell further comprises: an anti-reflection layer, disposed on a side of the transparent conductive layer on the front surface of the silicon substrate away from the silicon substrate; and
a light transmittance of the anti-reflection layer is greater than a light transmittance of the transparent conductive layer on the front surface of the silicon substrate.

A second aspect of the present disclosure further provides a method for preparing a heterojunction solar cell, wherein the method for preparing a heterojunction solar cell comprises:
texturing at least one of a front surface and a back surface of a silicon substrate, to obtain a textured surface having a pyramid structure;
forming a silicon-based thin film on the front surface and the back surface of the silicon substrate, the silicon-based thin film comprising an intrinsic layer and a doped layer disposed on a side of the intrinsic layer away from the silicon substrate, wherein a thickness of the silicon-based thin film covering the pyramid structure decreases closer to the silicon substrate; and
forming a transparent conductive layer and grid electrodes on a side of each silicon-based thin film away from the silicon substrate.

As described above, the embodiments of the present disclosure provide a heterojunction solar cell and a preparation method therefor. The heterojunction solar cell comprises: a silicon substrate comprising a front side and a back side, wherein at least one of the front surface and the back surface is provided as a textured surface having a pyramid structure; a silicon-based thin film disposed on the front surface and the back surface of the silicon substrate, the silicon-based thin film comprising an intrinsic layer and a doped layer disposed on a side of the intrinsic layer away from the silicon substrate; wherein a doping type of the doped layer on the front surface is opposite to a doping type of the doped layer on the back surface, and a thickness of the silicon-based thin film covering the pyramid structure decreases closer to the silicon substrate; and a transparent conductive layer and grid electrodes disposed on a side of each silicon-based thin film away from the silicon substrate. The pyramid tip of the pyramid structure is a stress concentration point, and the stress gradually decreases sequentially downward. During the film deposition process of the transparent conductive layer, because the silicon-based thin film at the pyramid tip is thicker, it can block the transparent conductive material in the pyramid tip region from being bombarded into the interface of the silicon substrate, thereby preventing interface recombination and improving the cell efficiency of the heterojunction solar cell.

### SUMMARY OF THE INVENTION

FIG. 1 shows a cross-sectional view of a heterojunction solar cell according to an embodiment of the present disclosure.
FIG. 2 shows a partial cross-sectional view of a pyramid structure in the heterojunction solar cell shown in FIG. 1.
FIG. 3 shows a partial cross-sectional view of a pyramid structure in the heterojunction solar cell shown in FIG. 1.
FIG. 4 shows a cross-sectional view of a heterojunction solar cell according to another embodiment of the present disclosure.
FIG. 5 shows a flowchart of a method for preparing a heterojunction solar cell according to an embodiment of the present disclosure.

### DETAILED DESCRIPTION

The following describes the implementations of the present disclosure through specific examples. Those skilled in the art can easily understand other advantages and effects of the present disclosure from the content disclosed herein. The present disclosure can also be implemented or applied through other different specific embodiments. Various details in this specification can also be modified or changed based on different viewpoints and applications without departing from the spirit of the present disclosure. It should be noted that the embodiments and features of the embodiments in the present disclosure may be combined with each other if there is no conflict.

Referring to the drawings, the embodiments of the present disclosure are described in detail to enable those skilled in the technical field of the present disclosure to readily implement them. The present disclosure may be embodied in many different forms and is not limited to the embodiments described herein.

In the description of the present disclosure, references to terms such as "one embodiment," "some embodiments," "example," "specific example," or "some examples" mean that specific features, structures, materials, or characteristics described in connection with the embodiment or example are included in at least one embodiment or example of the present disclosure. Moreover, the specific features, structures, materials, or characteristics described may be combined in any suitable manner in any one or more embodiments or examples. Furthermore, those skilled in the art can combine and integrate different embodiments or examples described in the present disclosure and features of different embodiments or examples without contradicting each other.

Furthermore, the terms "first" and "second" are used for descriptive purposes only and cannot be understood as indicating or implying relative importance or implicitly indicating the number of indicated technical features. Thus, features defined by "first" and "second" may explicitly or implicitly include at least one of the features. In the description of the present disclosure, "a plurality of" means two or more, unless otherwise specifically defined.

Although not differently defined, all terms used herein, including technical and scientific terms, have the same meaning as commonly understood by one of ordinary skill in the art. Terms defined in commonly used dictionaries should be interpreted as having meanings consistent with their meanings in the context of the relevant technology and the present disclosure, and should not be interpreted in an idealized or overly formal sense unless expressly so defined herein.

In the related art, the cell efficiency of heterojunction solar cells is low. Research on the problems existing in the related art shows that there are many factors affecting cell efficiency, for example, elements from the transparent conductive material entering the substrate interface, which causes severe interface recombination and affects cell efficiency.

Therefore, how to prevent elements from the transparent conductive material from entering the silicon substrate interface is the technical problem to be solved by the embodiments of the present disclosure.

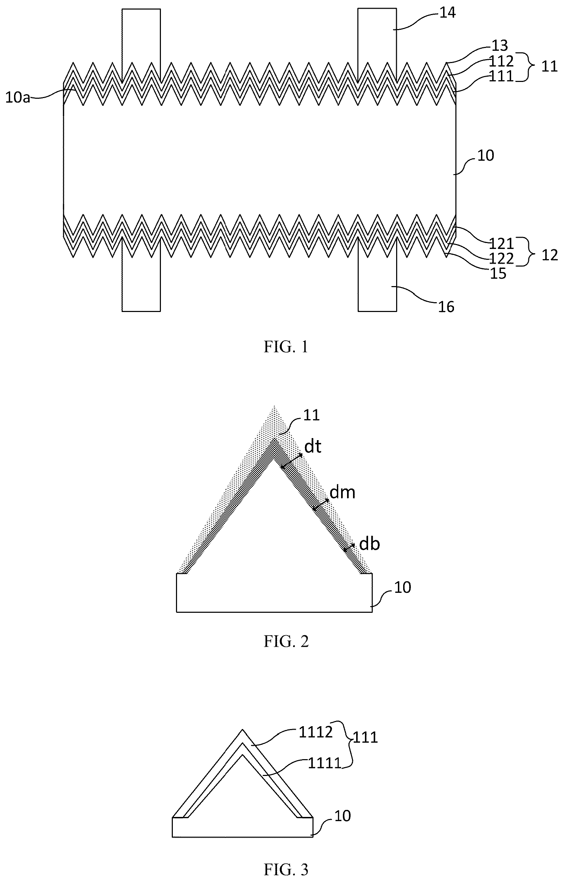

FIG. 1 shows a cross-sectional view of a heterojunction solar cell provided by an embodiment of the present disclosure. As shown in FIG. 1, the heterojunction solar cell comprises:
a silicon substrate 10, where both a front surface and a back surface of the silicon substrate 10 are provided as textured surfaces having a pyramid structure 10a;
a silicon-based thin film disposed on the front surface and the back surface of the silicon substrate 10, such as a first silicon-based thin film 11 on the front surface and a second silicon-based thin film 12 on the back surface; where the first silicon-based thin film 11 comprises a first intrinsic layer 111 and a first doped layer 112 disposed on a side of the first intrinsic layer 111 away from the silicon substrate 10, the second silicon-based thin film 12 comprises a second intrinsic layer 121 and a second doped layer 122 disposed on a side of the second intrinsic layer 121 away from the silicon substrate 10;
a transparent conductive layer and grid electrodes disposed on a side of each silicon-based thin film away from the silicon substrate 10, such as a first transparent conductive layer 13 and first grid electrodes 14 disposed on the front surface side of the silicon substrate 10, and a second transparent conductive layer 15 and second grid electrodes 16 disposed on the back surface side of the silicon substrate 10.

Referring to FIG. 2, the thickness of the first silicon-based thin film 11 covering the pyramid structure 10a on the front surface of the silicon substrate 10 decreases closer to the silicon substrate 10, for example, dt > dm > db. Correspondingly, the thickness of the second silicon-based thin film 12 covering the pyramid structure 10a also decreases closer to the silicon substrate 10.

In this embodiment, the pyramid tip is a stress concentration point, and the stress gradually decreases sequentially downward. During the film deposition process of the transparent conductive layers (such as the first transparent conductive layer 13 and the second transparent conductive layer 15), because the silicon-based thin film at the pyramid tip is thicker, it can block the transparent conductive material in the pyramid tip region from being bombarded into the interface of the silicon substrate, thereby preventing interface recombination and improving the cell efficiency of the heterojunction solar cell.

In an embodiment of the present disclosure, both the first intrinsic layer 111 and the second intrinsic layer 121 are double-layer structures. Referring to FIG. 3, taking the first intrinsic layer 111 as an example,the first intrinsic layer 111 comprises:
an intrinsic hydrogenated amorphous silicon oxide (i-α-SiOₓ:H) layer 1111 and an intrinsic hydrogenated nanocrystalline silicon layer 1112;
where the intrinsic hydrogenated amorphous silicon oxide layer 1111 is closer to the silicon substrate 10 (referring to FIG. 1) than the intrinsic hydrogenated nanocrystalline silicon layer 1112.

The intrinsic hydrogenated amorphous silicon oxide layer 1111 has a higher hydrogen content compared to intrinsic hydrogenated amorphous silicon. This design can improve passivation performance, reduce the probability of interface epitaxial crystal growth, and hydrogenated amorphous silicon oxide can prevent the growth of interface epitaxial crystals, broaden the process window, and simultaneously reduce parasitic absorption to some extent, improving the photogenerated current density of the cell.

The intrinsic hydrogenated nanocrystalline silicon layer 1112 has a higher structural order and a denser structure, and thus has better conductivity than intrinsic hydrogenated amorphous silicon, which can reduce the resistivity of the thin film and improve the fill factor (FF) of the cell.

In an embodiment of the present disclosure, a thickness of the intrinsic hydrogenated amorphous silicon oxide layer 1111 is 4-8 nm. Within this range, better passivation performance can be obtained, and the photogenerated current density can be improved.

In an embodiment of the present disclosure, a thickness of the intrinsic hydrogenated nanocrystalline silicon layer 1112 is 5-10 nm. Within this range, the first intrinsic layer 111 and the second intrinsic layer 121 have a denser structure.

In an embodiment of the present disclosure, the intrinsic layer may also be a single-layer structure, such as a single layer of intrinsic amorphous silicon (i-α-Si:H), which is not limited herein.

In an embodiment of the present disclosure, both the first doped layer 112 and the second doped layer 122 are doped microcrystalline silicon oxycarbide (µc-SiC_{y}Oₓ:H) layers. Doped microcrystalline silicon oxycarbide has microcrystallization and strong bonds. Microcrystallization can reduce defect density, and strong bonds (such as carbon-silicon bonds or silicon-oxygen bonds) can reduce subsequent device degradation. This embodiment uses µc-SiC_{y}Oₓ:H to break through the obstacles of the related art. Doped microcrystalline silicon oxycarbide achieves multi-component co-doping, which increases the optical band gap of amorphous silicon. This material possesses a high thin film band gap and a high thin film order degree, thereby reducing parasitic absorption, improving the conductivity of the thin film, increasing the cell current and fill factor, and further enhancing the photogenerated current density of the cell.

In an embodiment of the present disclosure, the doping type in the doped microcrystalline silicon oxycarbide is related to its position. When the silicon substrate 10 is N-type, the dopant in the first doped layer 112 is N-type dopant, such as phosphorus (P) dopant, and the dopant in the second doped layer 122 is P-type dopant, such as boron (B) or aluminum (Al). In this embodiment, the first doped layer 112 is high-carbon and low-oxygen, which can reduce the influence of the work function of the first transparent conductive layer 13 on the device efficiency.

In another embodiment, when the silicon substrate 10 is P-type, the dopant of the first doped layer 112 and the second doped layer 122 can be adapted accordingly.

That is, the doping source in the first doped layer 112 is different from that in the silicon substrate 10, while the doping source in the second doped layer 122 is the same type as that in the silicon substrate 10, so that the silicon substrate 10 and the silicon-based thin film 11 constitute a heterojunction unit.

In an embodiment of the present disclosure, thicknesses of both the first doped layer 112 and the second doped layer 122 are 5-10 nm.

In an embodiment of the present disclosure, the crystallization rate of the doped microcrystalline silicon oxycarbide layer increases in a direction from the silicon substrate 10 toward the grid electrodes. For example, the crystallization rate of the first doped layer 112 increases in a direction from the silicon substrate 10 toward the first grid electrodes 14, and the crystallization rate of the second doped layer 122 increases in a direction from the silicon substrate 10 toward the second grid electrodes 16. When generating doped microcrystalline silicon oxycarbide, the crystals are droplet-shaped, starting with a smaller size and later with a larger size, so the crystallization rate has the above trend.

In an embodiment of the present disclosure, the doped microcrystalline silicon oxycarbide layer located on the front surface of the silicon substrate has N-type dopant, an activation concentration of N-type dopant is not less than 1E+17/cm³; and the doped microcrystalline silicon oxycarbide layer located on the back surface of the silicon substrate has P-type dopant, an activation concentration of P-type dopant is not less than 1E+16/cm³.

In this embodiment, microcrystallization can increase the activation concentration of the dopant and improve the transport efficiencyof the carrier.

In an embodiment of the present disclosure, thicknesses of the first doped layer 112 and the second doped layer 122 are 60-80 nm.

In an embodiment of the present disclosure, the doping concentration of the doped layer increases in a direction from the silicon substrate 10 toward the grid electrodes. Specifically, the doping concentration of the first doped layer 112 increases in a direction from the silicon substrate 10 toward the first grid electrodes 14, and the doping concentration of the second doped layer 122 increases in a direction from the silicon substrate 10 toward the second grid electrodes 16. This design can prevent the diffusion of doping elements toward the intrinsic layer on the same side. If the doping concentration is too high at the interface between the intrinsic layer and the doped layer, during the manufacturing process, the doping elements may diffuse internally due to the large concentration difference, thereby affecting the passivation of the intrinsic layer.

In an embodiment of the present disclosure, the doped layer disposed on the front surface of the silicon substrate 10 (such as the first doped layer 112) has N-type dopant, and the doped layer disposed on the back surface of the silicon substrate 10 (such as the second doped layer 122) has P-type dopant; the grid density of the grid electrodes located on the front surface of the silicon substrate 10 (such as the first grid electrodes 14) is greater than the grid density of the grid electrodes located on the back surface of the silicon substrate 10 (such as the second grid electrodes 16).

The greater the grid density on the back surface of the silicon substrate 10, the shorter the lateral transmission distance of carriers in the second transparent conductive layer 15, the lower the probability of recombination, and the higher the fill factor of the cell.

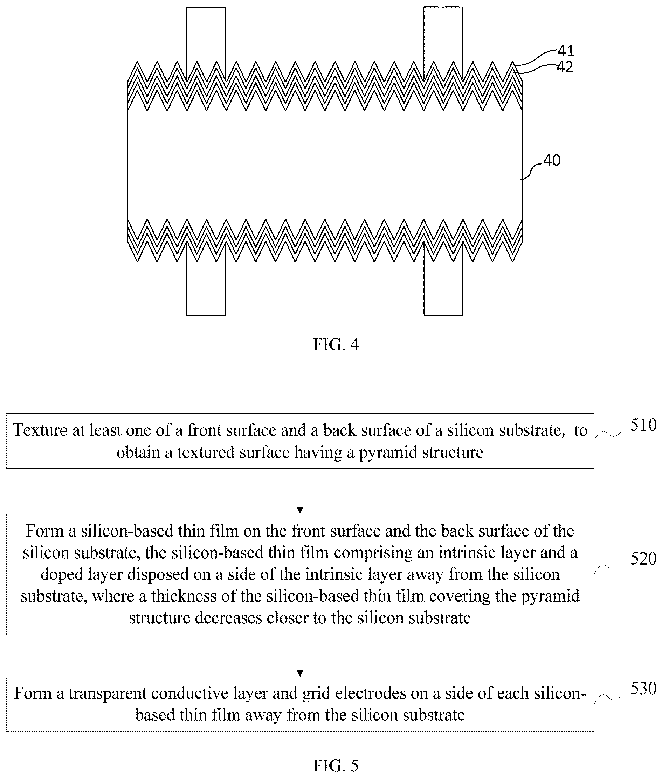

In another embodiment of the present disclosure, as shown in FIG. 4, the heterojunction solar cell further comprises:
an anti-reflection layer 41, disposed on a side of a first transparent conductive layer 42 on the front surface of a silicon substrate 40 away from the silicon substrate 40;
a light transmittance of the anti-reflection layer 41 is greater than a light transmittance of the first transparent conductive layer 42 on the front surface of the silicon substrate 40.

Compared to the first transparent conductive layer 42, the anti-reflection layer 41 has a higher light transmittance, to improve the photoelectric conversion efficiency of the heterojunction solar cell.

FIG. 5 shows a flowchart of a method for preparing a heterojunction solar cell according to an embodiment of the present disclosure. As shown in FIG. 5, the method for preparing the heterojunction solar cell may include, but is not limited to, the following steps:
Step 510: Texture at least one of a front surface and a back surface of a silicon substrate, to obtain a textured surface having a pyramid structure;
Step 520: Form a silicon-based thin film on the front surface and the back surface of the silicon substrate, the silicon-based thin film comprising an intrinsic layer and a doped layer disposed on a side of the intrinsic layer away from the silicon substrate, where a thickness of the silicon-based thin film covering the pyramid structure decreases closer to the silicon substrate;
Step 530: Form a transparent conductive layer and grid electrodes on a side of each silicon-based thin film away from the silicon substrate.

In this embodiment, the pyramid tip is a stress concentration point, and the stress gradually decreases sequentially downward. During the film deposition process of the transparent conductive layer, because the silicon-based thin film at the pyramid tip is thicker, it can block the transparent conductive material in the pyramid tip region from being bombarded into the interface of the silicon substrate, thereby preventing interface recombination and improving the cell efficiency of the heterojunction solar cell.

The heterojunction solar cell shown in FIG. 1 can be prepared by the method shown in FIG. 5, or other methods, which is not limited herein.

In some embodiments, when preparing the silicon-based thin film, the concentration of the deposition material in the pyramid tip region can be controlled so that the portion of the silicon-based thin film in the pyramid tip region is thicker. Further, the concentration of the deposition material can be gradually decreased from the pyramid tip toward both sides to achieve that the thickness of the silicon-based thin film covering the pyramid structure decreases closer to the silicon substrate.

In an embodiment of the present disclosure, the silicon substrate is N-type crystalline silicon n-c-Si. Before film deposition, cleaning and damage removal - texturing process are performed to form a textured surface with uniform pyramid structures. The RCA method is used for cleaning to remove surface organic matter and metal ions. The textured pyramid surface is subjected to smoothing treatment, and finally a hydrofluoric acid (HF) solution is used to remove the oxide layer.

In an embodiment of the present disclosure, in the silicon-based thin film preparation stage, Very High Frequency Plasma Enhanced Chemical Vapor Deposition (VHF-PECVD) or other deposition methods can be used to prepare the first intrinsic layer on the front surface of the silicon substrate. This first intrinsic layer can be i-α-Si:H or the structure of the intrinsic layer shown in FIG. 3. After flipping, the second intrinsic layer is prepared on the back surface of the silicon substrate. This second intrinsic layer can be i-α-Si:H or the structure of the intrinsic layer shown in FIG. 3. After flipping, N-type µc-SiC_{y}Oₓ:H is prepared on the side of the first intrinsic layer away from the silicon substrate. After flipping again, P-type µc-SiCₓO_{y}:H is prepared on the side of the second intrinsic layer away from the silicon substrate.

After completing the silicon-based thin film preparation stage, a Transparent Conductive Oxide (TCO) can be prepared on the front surface and the back surface of the silicon substrate as the transparent conductive layer through Physical Vapor Deposition (PVD) or Reactive Plasma Deposition (RPD). Finally, grid electrodes are prepared by screen printing and copper electroplating, followed by curing/annealing of the grid lines.

The foregoing embodiments are merely illustrative of the principles and efficacy of the present disclosure, and are not intended to limit the present disclosure. Any skilled in the art can modify or change the above embodiments without departing from the spirit and scope of the present disclosure. Therefore, all equivalent modifications or changes made by those of ordinary skill in the art without departing from the spirit and technical idea disclosed in the present disclosure should still be covered by the claims of the present disclosure.

## Claims

1. A heterojunction solar cell, **characterized by** comprising:
a silicon substrate comprising a front side and a back side, wherein at least one of the front surface and the back surface is provided as a textured surface having a pyramid structure;
a silicon-based thin film disposed on the front surface and the back surface of the silicon substrate, the silicon-based thin film comprising an intrinsic layer and a doped layer disposed on a side of the intrinsic layer away from the silicon substrate; wherein a doping type of the doped layer on the front surface is opposite to a doping type of the doped layer on the back surface, and a thickness of the silicon-based thin film covering the pyramid structure decreases closer to the silicon substrate; and
a transparent conductive layer and grid electrodes disposed on a side of each silicon-based thin film away from the silicon substrate.

2. The heterojunction solar cell according to claim 1, wherein the intrinsic layer is a double-layer structure;
the intrinsic layer comprises: an intrinsic hydrogenated amorphous silicon oxide layer and an intrinsic hydrogenated nanocrystalline silicon layer; and
the intrinsic hydrogenated amorphous silicon oxide layer is closer to the silicon substrate than the intrinsic hydrogenated nanocrystalline silicon layer.

3. The heterojunction solar cell according to claim 2, wherein a thickness of the intrinsic hydrogenated amorphous silicon oxide layer is 4-8 nm.

4. The heterojunction solar cell according to claim 2, wherein a thickness of the intrinsic hydrogenated nanocrystalline silicon layer is 5-10 nm.

5. The heterojunction solar cell according to claim 1, wherein the doped layer is a doped microcrystalline silicon oxycarbide layer.

6. The heterojunction solar cell according to claim 5, wherein the doped microcrystalline silicon oxycarbide layer located on the front surface of the silicon substrate has N-type dopant, an activation concentration of N-type dopant is not less than 1E+17/cm³; and the doped microcrystalline silicon oxycarbide layer located on the back surface of the silicon substrate has P-type dopant, an activation concentration of P-type dopant is not less than 1E+16/cm³.

7. The heterojunction solar cell according to claim 1, wherein a doping concentration of the doped layer increases in a direction from the silicon substrate toward the grid electrodes.

8. The heterojunction solar cell according to claim 1, wherein the doped layer disposed on the front surface of the silicon substrate has N-type dopant,
the doped layer disposed on the back surface of the silicon substrate has P-type dopant; and
a grid density of the grid electrodes located on the front surface of the silicon substrate is greater than a grid density of the grid electrodes located on the back surface of the silicon substrate.

9. The heterojunction solar cell according to claim 1, wherein the heterojunction solar cell further comprises: an anti-reflection layer, disposed on a side of the transparent conductive layer on the front surface of the silicon substrate away from the silicon substrate; and
a light transmittance of the anti-reflection layer is greater than a light transmittance of the transparent conductive layer on the front surface of the silicon substrate.

10. The heterojunction solar cell according to claim 1, wherein the intrinsic layer is a single-layer structure, and the intrinsic layer comprises: a single intrinsic amorphous silicon layer.

11. The heterojunction solar cell according to claim 1, wherein,
the front surface and the back surface of the silicon substrate are both provided as textured surfaces having a pyramid structure;
the silicon-based thin film disposed on the front surface of the silicon substrate is a first silicon-based thin film, and the silicon-based thin film disposed on the back surface of the silicon substrate is a second silicon-based thin film;
the first silicon-based thin film comprises a first intrinsic layer and a first doped layer disposed on a side of the first intrinsic layer away from the silicon substrate; and
the second silicon-based thin film comprises a second intrinsic layer and a second doped layer disposed on a side of the second intrinsic layer away from the silicon substrate.

12. The heterojunction solar cell according to claim 11, wherein,
the silicon substrate is an N-type silicon substrate;
a doping type of the first doped layer is N-type doping, and a doping element is phosphorus; and
a doping type of the second doped layer is P-type doping, and a doping element is boron or aluminum.

13. The heterojunction solar cell according to claim 11, wherein a thickness of the first doped layer is 60-80 nm, and a thickness of the second doped layer is 60-80 nm.

14. A method for preparing a heterojunction solar cell, **characterized by** comprising:
texturing at least one of a front surface and a back surface of a silicon substrate, to obtain a textured surface having a pyramid structure;
forming a silicon-based thin film on the front surface and the back surface of the silicon substrate, the silicon-based thin film comprising an intrinsic layer and a doped layer disposed on a side of the intrinsic layer away from the silicon substrate, wherein a thickness of the silicon-based thin film covering the pyramid structure decreases closer to the silicon substrate; and
forming a transparent conductive layer and grid electrodes on a side of each silicon-based thin film away from the silicon substrate.

15. The method for preparing a heterojunction solar cell according to claim 14, wherein the intrinsic layer is a double-layer structure;
the intrinsic layer comprises: an intrinsic hydrogenated amorphous silicon oxide layer and an intrinsic hydrogenated nanocrystalline silicon layer; and
the intrinsic hydrogenated amorphous silicon oxide layer is closer to the silicon substrate than the intrinsic hydrogenated nanocrystalline silicon layer.

16. The method for preparing a heterojunction solar cell according to claim 15, wherein a thickness of the intrinsic hydrogenated amorphous silicon oxide layer is 4-8 nm, and a thickness of the intrinsic hydrogenated nanocrystalline silicon layer is 5-10 nm.

17. The method for preparing a heterojunction solar cell according to claim 14, wherein the doped layer is a doped microcrystalline silicon oxycarbide layer.

18. The method for preparing a heterojunction solar cell according to claim 17, wherein the doped microcrystalline silicon oxycarbide layer located on the front surface of the silicon substrate has N-type dopant, an activation concentration of N-type dopant is not less than 1E+17/cm³; and the doped microcrystalline silicon oxycarbide layer located on the back surface of the silicon substrate has P-type dopant, an activation concentration of P-type dopant is not less than 1E+16/cm³.

19. The method for preparing a heterojunction solar cell according to claim 14, wherein a doping concentration of the doped layer increases in a direction from the silicon substrate toward the grid electrodes.

20. The method for preparing a heterojunction solar cell according to claim 14, wherein the doped layer disposed on the front surface of the silicon substrate has N-type dopant, and the doped layer disposed on the back surface of the silicon substrate has P-type dopant; and
a grid density of the grid electrodes located on the front surface of the silicon substrate is greater than a grid density of the grid electrodes located on the back surface of the silicon substrate.
